# EUROPEAN PATENT SPECIFICATION

(11) **EP 2 850 635 B1**
(45) Date of publication and mention of the grant of the patent: **27.04.2016**
(21) Application number: 13722748.4
(22) Date of filing: 14.05.2013
(51) Int. Cl.: H01J 37/04, H01J 37/317

(54) **CHARGED PARTICLE MULTI-BEAMLET LITHOGRAPHY SYSTEM AND COOLING ARRANGEMENT MANUFACTURING METHOD**
LADUNGSTRÄGER-LITHOGRAFIESYSTEM MIT MEHREREN TEILSTRAHLEN UND KÜHLANORDNUNGSHERSTELLUNGSVERFAHREN
PROCÉDÉ DE FABRICATION DE SYSTÈME LITHOGRAPHIQUE À PETITS FAISCEAUX MULTIPLES DE PARTICULES CHARGÉES ET DE SYSTÈME DE REFROIDISSEMENT

(30) Priority: 14.05.2012 US 201261646398 P
(43) Date of publication of application: 25.03.2015
(73) Proprietor: Mapper Lithography IP B.V., 2628 XK Delft (NL)
(72) Inventor: SPRENGERS, Johannes Petrus, NL-2497 TL Den Haag (NL); OTTEN, Christiaan, NL-3402 VH Ijsselstein (NL); JAGER, Remco, NL-3011 XW Rotterdam (NL); STEENBRINK, Stijn Willem Herman Karel, NL-2593 EC Den Haag (NL); KONING, Johan Joost, NL-2182 RG Hillegom (NL); URBANUS, Willem Henk, NL-4101 ZJ Culemborg (NL); VAN VEEN, Alexander Hendrik Vincent, NL-3039 ER Rotterdam (NL)
(86) International application number: PCT/EP2013/059948
(87) International publication number: WO 2013/171216

(56) References cited:
- JP-A- 2006 140 267
- US-A1- 2012 273 690

## Description

### BACKGROUND OF THE INVENTION

### 1. Field of the Invention

The present invention relates to a charged particle multi-beamlet lithography system. The invention further relates to manufacturing a cooling arrangement for use within such lithography system.

### 2. Description of the Related Art

In the semiconductor industry, an ever increasing desire exists to manufacture smaller structures with high accuracy and reliability. Lithography is a critical part of such manufacturing process. Currently, most commercial lithography systems use a light beam and mask as a means to reproduce pattern data for exposing a target, such as a wafer with a coating of resist thereon. In a maskless lithography system, charged particle beamlets may be used to transfer a pattern onto such target. The beamlets may be individually controllable to obtain the desired pattern.

However, for such charged particle lithography systems to be commercially viable, they need to handle a certain minimum throughput, i.e. the number of wafer being processed per hour should not be too far below the number of wafers per hour that are currently processed with an optical lithography system. Furthermore, the charged particle lithography systems need to meet low error margins. The combination of a relatively high throughput in combination with the requirement to meet low error margins is challenging.

A higher throughput may be obtained by using more beamlets, and therefore more current. However, handling a greater number of beamlets results in the need for more control circuitry. Furthermore, an increase in the current results in more charged particles that interact with components in the lithography system. Both the circuitry and the impingement of charged particles onto components may cause heating of the respective components within the lithography system. Such heating may reduce the accuracy of the patterning process within the lithography system. In a worst case scenario, such heating may stop one or more components within the lithography system from functioning.

Japanese patent document JP2006140267 discloses a charged particle multi beam exposure device in which the thermal load of an aperture array under irradiation of electron beam is reduced for improved precision in lithography.

### BRIEF SUMMARY OF THE INVENTION

It is an object of the invention to provide a charged particle multi-beamlet lithography system with improved performance regarding heat management. For this purpose, the invention provides a charged particle multi-beamlet lithography system for exposing a target using a plurality of charged particle beamlets according to claim 1. The system comprising: a beamlet generator for generating the charged particle beamlets; a beamlet modulator for patterning the beamlets to form modulated beamlets, a beamlet projector for projecting the modulated beamlets onto a surface of the target; wherein the beamlet generator, beamlet modulator and/or beamlet projector comprise one or more plates provided with a plurality of apertures for letting the beamlets pass through the plate, the apertures being arranged in groups to form on the surface of the one or more plates a plurality of beam areas distinct and separate from a plurality of non-beam areas containing no apertures for passage of the beamlets; and wherein at least one of the plates with apertures in the lithography system is provided with a cooling arrangement disposed on its surface in one or more non-beam areas, the cooling arrangement comprising a plate-shaped body provided with an inlet for receiving a cooling liquid, a plurality of cooling channels for arranging flow of a cooling liquid therein, and an outlet for removing the cooling liquid. The plate-shaped body of the cooling arrangement is provided with a plurality of slots between the cooling channels, wherein the slots are substantially aligned with the beam areas on the aperture plate surface.

The inlet and the plurality of cooling channels are connected to each other via a single distribution channel, the single distribution channel comprising a diffuser section for diffusing cooling liquid and a splitting section for dividing the cooling liquid over the plurality of cooling channels.

The term "beam area" refers herein to an area on the surface of the plate (e.g. in the beamlet generator, beamlet modulator, or beamlet projector) wherein apertures are arranged in groups, these apertures being arranged to provide passage for the beamlets. The "non-beam areas" are areas which are not exposed to charged particle beamlets. The disposal of a cooling arrangement in the form of a plate-shaped body onto the aperture plate enables effective cooling in those areas where the cooling arrangement does not interfere with the operation of the lithography system.

The use of a plurality of cooling channels connected to an inlet and an outlet allows for sufficient supply of cooling liquid in combination with an adequate spatial distribution of the cooling liquid throughout the cooling arrangement while occupying limited space within the lithography system. The plate-shaped body of the cooling arrangement may be formed with a substantially planar portion i.e. a flat surface. In particular, the plate-shaped body may comprise a flat surface that spans a contact plane for connecting to the plate provided with apertures. The flat surface provides an interface region for bringing the plate-shaped body into thermal contact with a flat region of the plate with apertures in such a manner that the flat body surface and the flat plate region are substantially parallel and directly abutting, or substantially parallel and thermally connected via an intermediate layer of thermally conductive material (e.g. an adhesive layer).

The cooling channels may be arranged mutually parallel to define a flow direction that is parallel with the contact plane. The cooling channels may thus run parallel side by side through the planar portion of the body, and parallel to the plane of the planar portion. The (substantially) parallel alignment may be obtained within the achievable manufacturing and alignment tolerances. A relatively large misalignment for the plate-shaped body and/or channels would be undesirable, for this would significantly perturb the charged particle beam generation and manipulation functions performed by the beamlet generator, beamlet modulator and/or beamlet projector, which in turn would deteriorate the results of lithography. For a lithography system provided with a cooling arrangement with cooling channels and slots in the millimeter range (e.g. according to embodiments described herein below), any deviation from parallel alignment would preferably result in absolute displacements that stay below 0.5 millimeters, more preferably below 100 micrometers.

The slots enable passage of the charged particle beamlets through the plate-shaped body of the cooling arrangement. Furthermore, the use of a single plate-shaped structure with slots reduces the number of components within the cooling arrangement. Furthermore, suitable alignment of the slots enable contact of the cooling arrangement with the aperture plate at all places where such contact is reasonably possible without interfering with the operation of the lithography system. An increase in contact area may increase the amount of heat the cooling arrangement can absorb. The slots may have an elongate shape along the flow direction, and each slot may lie between two adjacent cooling channels viewed transverse to the flow direction.

In some embodiments, the diffuser section has a first cross-sectional area at a side facing the inlet and a second cross-sectional area facing the plurality of cooling channels; wherein the first cross-sectional area and the second cross-sectional area are equal; and wherein the height of the first cross-sectional area is greater than the height of the second cross-sectional area, the height in a direction perpendicular to a planar portion of the plate-shaped body through which the cooling channels run. The use of such distribution channel allows for the supply of a relatively large amount of cooling liquid at a controllable speed. In some embodiments, the plate-shaped body with the inlet and the outlet are provided entirely on one side of the contact plane spanned by the flat surface.

In some embodiments, the plate-shaped body of the cooling arrangement is connected to the at least one plate provided with apertures by means of an adhesive layer. The adhesive layer ensures that the entire connected surface of the cooling arrangement can be used for removing heat from the aperture plate. Preferably, the adhesive layer has an overall heat transfer coefficient greater than 100 kW/m²·K, preferably greater than 150 kW/ m²·K.

In some embodiments, the system further comprises a coolant system arranged to provide cooling liquid to the inlet of the cooling arrangement at a sufficiently high flow speed to produce a turbulent flow of cooling liquid through the plurality of cooling channels. A turbulent flow can accommodate more heat from the aperture plate than a laminar flow. Furthermore, an increase of the flow speed reduces the difference in cooling liquid temperature between the exit of a cooling channel and the entrance of that cooling channel.

In some embodiments, the beamlet modulator comprises a beamlet blanker array and a beamlet stop array, and the plate-shaped body of the cooling arrangement is disposed on a surface of the beamlet blanker array. The beamlet blanker array is subject to significant heating due to the presence of control circuitry to modulate beamlets passing there through.

In some other embodiments, the coolant system may be arranged for providing cooling liquid to the inlet of the plate-shaped body of the cooling arrangement at a sufficiently low flow speed to produce a laminar flow of cooling liquid through the plurality of cooling channels. A laminar flow introduces fewer vibrations that could jeopardize the performance of the aperture pate that is being cooled. Components that may benefit from a cooling structure being provided with cooling liquid in the laminar flow regime include, but are not limited to the beamlet stop array and a lens plate within the beamlet projector.

Preferably, the cooling liquid comprises water. Water has sufficient heat capacity and is easier to use than other known cooling liquids, such as ammonia.

Embodiments of the invention further relate to a method of manufacturing a cooling body for use on top of a surface of a plate provided with a plurality of apertures for use in a multi-beamlet charged particle lithography system. The apertures are arranged in groups to form a plurality of beam areas on the surface of the plate.

In some embodiments, the method comprises: providing a first plate-shaped body, a surface side of the first body being provided with a first cut-out volume in accordance with a first lay-out; providing a second plate-shaped body, a surface side of the second body being provided with a second cut-out volume in accordance with a second lay-out; providing a plurality of slots in the first and second plate-shaped bodies, wherein the slots are arranged to be aligned with the beam areas on the aperture plate surface, and connecting the surfaces of the first body and the second body onto each other such that the first cut-out volume and the second cut-out volume form a plurality of cooling channels within an assembled body, wherein the slots are arranged between the cooling channels, the plurality of cooling channels connecting an inlet at a side of the assembled body with an outlet at another side of the assembled body. Connecting may be performed by providing an adhesive layer between the surfaces of the first body and the second body. Such method is in particular useful if at least one of the first body and the second body comprises Aluminum Nitride.

In some other embodiments, the method comprises: providing a plate-shaped body, a surface side of the body being provided with a cut-out volume in accordance with a lay-out; providing a plurality of slots in the plate-shaped body, wherein the slots are arranged to be aligned with the beam areas on the aperture plate surface; and covering the cut-out volume so as to form a plurality of cooling channels within the body, wherein the slots are arranged between the cooling channels, the plurality of cooling channels connecting an inlet at a side of the body with an outlet at another side of the body. Covering may include connecting one or more cover plates on the body by means of laser welding. Such embodiment is particularly useful if the body is made of titanium.

The cut-out volume formed in accordance with the lay-out of the cooling channels, may define a cut-out aperture on a flat surface of the plate-shaped body. The cut-out volume may then be sealed with a cover plate having a shape complementary to the cut-out aperture and arranged to cover the cut/out volume flush with the flat surface, so as to form the plurality of cooling channels on an interior of the body.

Alternatively, covering may include adhering the aperture plate to be cooled onto the body. Such embodiment is in particular useful for cases in which a laminar flow is desirable. The aperture plate partially forms a wall of the cooling channels which enhances heat transfer between the body and the cooling liquid flowing through the cooling channels.

It will be evident that the presently invented principle may be set into practice in various manners.

### BRIEF DESCRIPTION OF THE DRAWINGS

Various aspects of the invention will be further explained with reference to embodiments shown in the drawings wherein:
FIG. 1 is a simplified schematic drawing of an embodiment of a charged particle multi-beamlet lithography system;
FIG. 2 shows a simplified diagram of an electron optical column according to an embodiment of the invention;
FIG. 3 shows a schematic cross-sectional view of a portion of a beamlet blanker array provided with a cooling channel;
FIG. 4A shows an elevated cross-sectional top view of the cooling arrangement;
FIG. 4B is a cross-sectional view of the cooling arrangement of FIG. 4A;
FIG. 5 shows a portion of the cooling fluid channel lay-out according to an embodiment of the invention;
FIG. 6 shows a top view of the cooling fluid channel lay-out of FIG. 5;
FIGS. 7A, 7B schematically show cross-sectional views of a portion of the cooling arrangement;
FIGS. 8A, 8B show an elevated bottom and top view of a cooling arrangement according to an embodiment of the invention;
FIGS. 9A, 9B show an elevated top and bottom view of another cooling arrangement according to an embodiment of the invention; and
FIGS. 10A, 10B show an elevated top and bottom of the cooling arrangement of FIGS. 9A, 9B disposed on a beamlet stop array.
FIGS. 11A, 11B show an elevated bottom and top view of a cooling arrangement according to an alternative embodiment of the invention;

### DESCRIPTION OF ILLUSTRATIVE EMBODIMENTS

The following is a description of various embodiments of the invention, given by way of example only and with reference to the drawings.

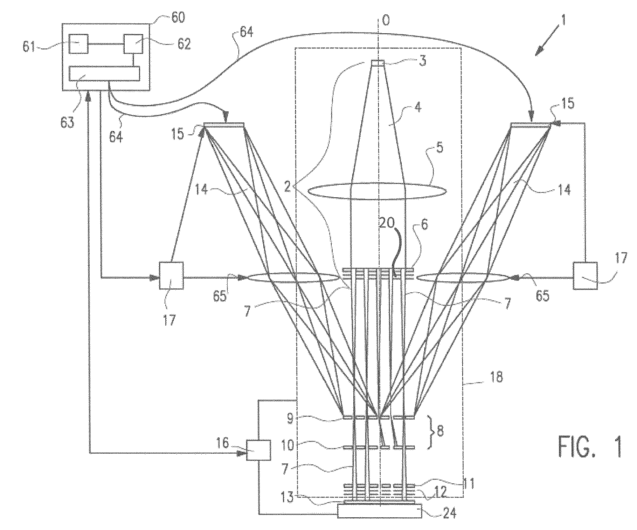

FIG. 1 shows a simplified schematic drawing of an embodiment of a charged particle lithography apparatus 1. Such lithography systems are described for example in U.S. Patent Nos. 6,897,458 and 6,958,804 and 7,019,908 and 7,084,414 and 7,129,502, U.S. patent application publication no. 2007/0064213, and co-pending U.S. patent applications Serial Nos. 61/031,573 and 61/031,594 and 61/045,243 and 61/055,839 and 61/058,596 and 61/101,682, which are all assigned to the owner of the present invention.

In the embodiment shown in FIG. 1, the lithography apparatus 1 comprises a beamlet generator 2 for generating a plurality of beamlets, a beamlet modulator 8 for patterning the beamlets to form modulated beamlets, and a beamlet projector for projecting the modulated beamlets onto a surface of a target **13.** The beamlet generator **2** typically comprises a source **3** for producing a charged particle beam **4.** In FIG. 1, the source **3** produces a substantially homogeneous, expanding charged particle beam **4.** Hereafter, embodiments of the invention will be discussed with reference to an electron beam lithography system. Therefore, source **3** may be referred to as electron source **3** and beam **4** may be referred to as electron beam **4.** It must be understood that a similar system as depicted in FIG. 1 may be used with a different type of radiation, for example by using an ion source for producing an ion beam.

In the embodiment shown in FIG. 1, the beamlet generator **2** further comprises a collimator lens **5** for collimating the electron beam **4** produced by the electron source **3,** and an aperture array **6** for forming a plurality of beamlets **7.** The collimator lens **5** may be any type of collimating optical system. Before collimation, the electron beam **4** may pass a double octopole (not shown). Preferably, the aperture array **6** comprises a plate provided with a plurality of through holes. The aperture array **6** blocks part of the electron beam **4,** whereas a portion of the electron beam **4** passes the aperture array **6** through the holes so as to produce the plurality of electron beamlets **7.** The system generates a large number of beamlets **122,** preferably about 10,000 to 1,000,000 beamlets.

The beamlet modulator or modulation system **8** in the embodiment of FIG. 1 comprises a beamlet blanker array **9** and a beamlet stop array **10.** The beamlet blanker array **9** comprises a plurality of blankers for deflecting one or more of the electron beamlets **7.** The deflected and undeflected electron beamlets **7** arrive at beam stop array **10,** which has a plurality of apertures. The beamlet blanker array **9** and beam stop array **10** operate together to block or let pass the beamlets **7.** Generally, if beamlet blanker array **9** deflects a beamlet **7,** it will not pass through the corresponding aperture in beam stop array **10,** but instead will be blocked. However, if beamlet blanker array **9** does not deflect a beamlet **7,** then it will pass through the corresponding aperture in beam stop array **10.** Alternatively, beamlets **7** may pass the beamlet stop array **10** upon deflection by corresponding blankers in the beamlet blanker array **9** and be blocked by the beamlet stop array **10** if they are not deflected. To focus the beamlets **7** within the plane of the blanker array **9** the lithography system **1** may further comprise a condenser lens array **20.**

The beamlet modulator **8** is arranged to provide a pattern to the beamlets **7** on the basis of pattern data input provided by a control unit **60.** The control unit **60** comprises a data storage unit **61,** a read out unit **62** and a data conversion unit **63.** The control unit **60** may be located remotely from the rest of the system, for example outside the clean room. The pattern data may be transferred via optical fibers **64.** The light transmitting ends of the optical fibers **64** may be assembled in one or more fiber arrays **15.** The pattern data carrying light beams **14** are then projected onto corresponding light receiving elements, such as photodiodes, provided on the beamlet blanker array **9.** Such projection may be done directly, or via projection system, in FIG. 1 schematically represented by projection lenses **65.** One or more elements in such projections system, such as projection lenses **65,** may be moveable under control of the control unit **60** via a positioning device **17** to enable proper alignment and/or focusing of the data carrying light beams **14** onto the corresponding light sensitive elements in the beamlet blanker array **9.**

The light sensitive elements are coupled to one or more blankers and are arranged to convert the light signal into a different type of signal, for example an electric signal. A pattern data carrying light beam **14** may carry data for one or more blankers within the beamlet blanker array **9.** The pattern data is thus sent via the pattern data carrying light beams towards the blankers to enable the blankers to modulate the charged particle beamlets 7 passing there through in accordance with a pattern.

The modulated beamlets coming out of the beamlet modulator **8** are projected onto a target surface of a target **13** by the beamlet projector. The beamlet projector comprises a beamlet deflector array **11** for scanning the modulated beamlets over the target surface and a projection lens arrangement **12** comprising one or more arrays of projection lenses for focusing the modulated beamlets onto the target surface. The target **13** is generally positioned on a moveable stage **24,** which movement may be controlled by a control unit such as control unit **60.**

For lithography applications, the target usually comprises a wafer provided with a charged-particle sensitive layer or resist layer. Portions of the resist film will be chemically modified by irradiation of the beamlets of charged particles, i.e. electrons. As a result thereof, the irradiated portion of the film will be more or less soluble in a developer, resulting in a resist pattern on a wafer. The resist pattern on the wafer can subsequently be transferred to an underlying layer, i.e. by implementation, etching and/or deposition steps as known in the art of semiconductor manufacturing. Evidently, if the irradiation is not uniform, the resist may not be developed in a uniform manner, leading to mistakes in the pattern. High-quality projection is therefore relevant to obtain a lithography system that provides a reproducible result.

The deflector array **11** and the projection lens arrangement **12** may be integrated into a single end module. Such end module is preferably constructed as an insertable, replaceable unit. The insertable, replaceable unit may also include the beamlet stop array **10.**

The deflector array **11** may take the form of a scanning deflector array arranged to deflect each beamlet **7** that passes through the beamlet stop array **10.** The deflector array **11** may comprise a plurality of electrostatic deflectors enabling the application of relatively small driving voltages. Although the deflector array **11** is drawn upstream of the projection lens arrangement **12,** the deflector array **11** may also be positioned between the projection lens arrangement **12** and the target surface **13.**

The projection lens arrangement **12** may thus be arranged to focus the beamlets **7** before or after deflection by the deflector array **11.** Preferably, the focusing results a geometric spot size of about 10 to 30 nanometers in diameter. In such preferred embodiment, the projection lens arrangement **12** is preferably arranged to provide a demagnification of about 100 to 500 times, most preferably as large as possible, e.g. in the range 300 to 500 times. In this preferred embodiment, the projection lens arrangement **12** may be advantageously located close to the target surface **13.**

The charged particle lithography apparatus **1** operates in a vacuum environment. A vacuum is desired to remove particles which may be ionized by the charged particle beams and become attracted to the source, may dissociate and be deposited onto the machine components, and may disperse the charged particle beams. A vacuum of at least 10⁻⁶ bar is typically required. Preferably, all of the major elements of the lithography apparatus **1** are housed in a common vacuum chamber, including the beamlet generator **2** including the charged particle source **3,** the beamlet modulator **8,** the beamlet projector system, and the moveable stage **24.** These major elements are also referred to as the electron-optical column, or simply as the column, and is schematically represented by the dashed box **18** in FIG. 1.

In an embodiment the charged particle source environment is differentially pumped to a considerably higher vacuum of up to 10⁻¹⁰ mbar. In such embodiment, the source **3** may be located in a separate chamber, i.e. a source chamber. Pumping down the pressure level in the source chamber may be performed in the following way. First, the vacuum chamber and the source chamber are pumped down to the level of the vacuum chamber. Then the source chamber is additionally pumped to a desired lower pressure, preferably by means of a chemical getter in a manner known by a skilled person. By using a regenerative, chemical and so-called passive pump like a getter, the pressure level within the source chamber can be brought to a lower level than the pressure level in the vacuum chamber without the need of a vacuum turbo pump for this purpose. The use of a getter avoids the interior or immediate outside vicinity of the vacuum chamber being submitted to acoustical and/or mechanical vibrations as would be the case if a vacuum turbo pump or similar would be used for such a purpose.

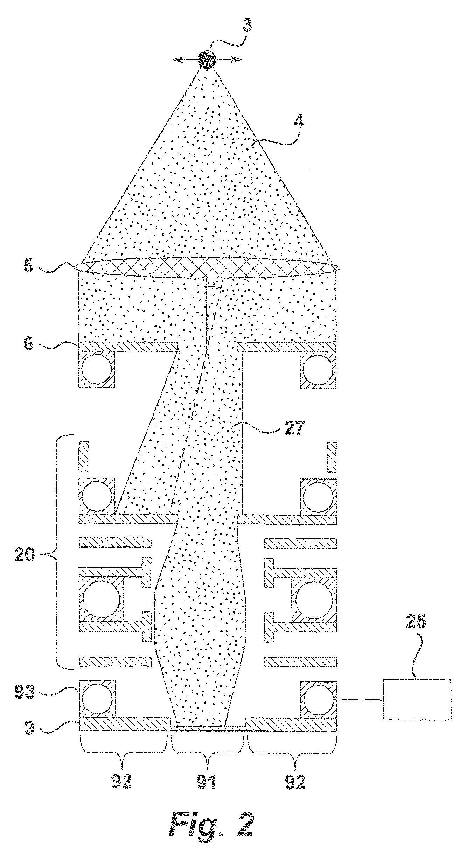

FIG. 2 shows a simplified diagram of an electron optical column according to an embodiment of the invention. In FIG. 2, a group of beamlets is depicted as a single beam **27.** The group of beamlets **27** passes through an aperture array **6** and subsequently through one or more condenser lens arrays **20** until the group **27** arrives at a beamlet blanker array **9.** The beamlet blanker array **9** may comprise an aperture array, which then forms an integral part of the blanker array **9.** Alternatively, such aperture array may be a separate array being positioned upstream the blanker array **9.** The use of an additional aperture array upstream of the blanker array **9** reduces the heat load of the blanker array **9.**

The beamlet blanker array **9** is divided into beam areas **91** and non-beam areas **92.** The beam areas **91** are areas provided with apertures and are arranged to receive and modulate beamlets passing through these apertures. The non-beam areas **92** are areas which are not exposed to charged particle beamlets. These non-beam areas **92** are arranged to provide an area for components needed to support the components within the beam areas **91.** For example, the non-beam areas **92** may accommodate light sensitive elements, such as photodiodes, for receiving data pattern carrying or modulated light signals, and electrical connections via which the light signals may be forwarded to modulators within the beam areas **91.**

In the embodiment depicted in FIG. 2 components such as photodiodes and electrical circuits in the non-beam areas are placed at a surface side of the blanker array **9** facing away from the source **3,** hereafter referred to as the target side of the blanker array **9.** On the surface side of the blanker array **9** facing the source **3,** hereafter the source side of the blanker array **9,** a cooling arrangement **93** is provided. The cooling arrangement **93** comprises one or more cooling channels for accommodating a flow of a cooling fluid, such as water. and water flowing in the channels can be placed on an upper surface of non-beam areas 92. The cooling arrangement **93** is located within the non-beam areas **92** of the blanker array **9** to avoid that any components thereof may block or directly interact with charged particles from the group of beamlets **27.**

The cooling arrangement **93** may be coupled to a coolant system 25 for providing cooling fluid to the inlet of the cooling arrangement at a suitable speed. In some embodiments, in particular if maximum use is to be made of the cooling capacity of the cooling fluid, such flow speed should be sufficiently high to produce a turbulent flow of cooling fluid through the plurality of cooling channels. However, if the operation of the structure to be cooled is very sensitive for vibrations, the coolant system may be arranged to provide the cooling fluid with a sufficiently low flow speed to produce a laminar flow of cooling fluid through the plurality of cooling channels. The cooling arrangement **93** may also include measures to create a certain type of flow, e.g. a turbulent flow or a laminar flow.

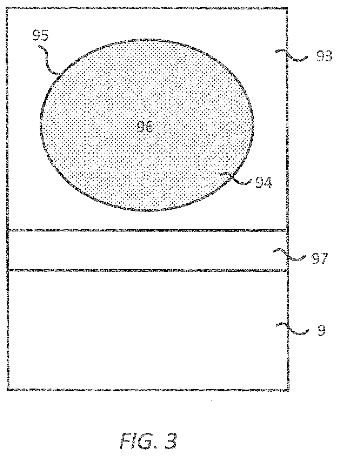

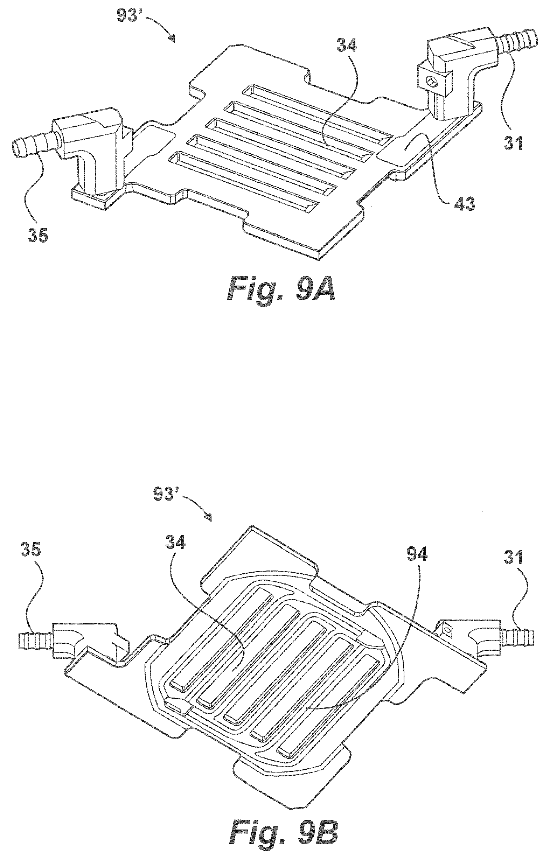

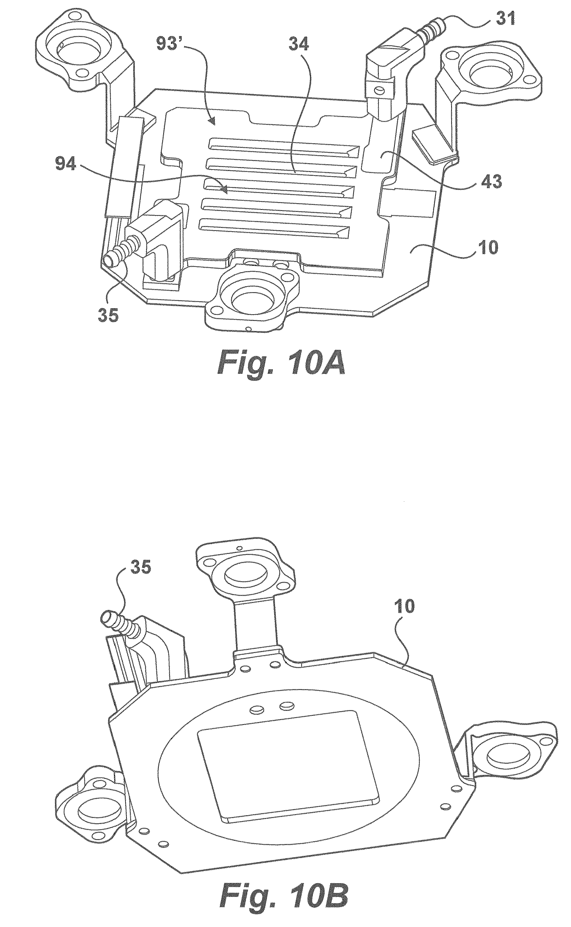

With reference to FIGS. 3-8, embodiments of the invention will be discussed in which a cooling arrangement is disposed on top of a beamlet blanker array **9.** Additionally, with reference to FIGS. 9 and 10, embodiments of the invention will be discussed in which a cooling arrangement is disposed on top of a beamlet stop array. However, it must be understood, as will be apparent from the column shown in FIG. 2, that such cooling arrangement may be provided on surface of other components within the electron optical column. In particular, embodiments of the cooling arrangement may be used on a surface of a plate provided with a plurality of apertures for letting the beamlets pass through the plate. Examples of such plates include but are not limited to an aperture array such as aperture array **6,** a lens plate such as a plate that is part of the one or more condenser lens arrays **20** or a plate that is part of the projector lens arrangement **12** shown in FIG. 1, and a plate in a beamlet modulator **8,** such as beamlet blanker array **9** and/or beamlet stop array **10.** The apertures do not need to be current limiting apertures. In some cases, heat may be generated by other means than impingement of charged particles within the charged particle beamlets. For example, the beamlet blanker array **9** comprises electronic circuitry that generates heat. Furthermore, charged particles may scatter upon components resulting in secondary charged particles which may transfer energy to other components as well.

The cooling fluid preferably comprises water. Water is easier to use than other known cooling fluids, such as ammonia. Ammonia requires a high pressure system and more extensive safety measures. In principle, a liquid metal, such as liquid gallium, could also be used, however water has a much larger allowable flow speed range than gallium, and the use of gallium introduces other complications such as solidification, cost, corrosivity, and diffusion. In case of water, a suitable temperature at the inlet **31** appears to be 15-25 °C, preferably about 20 °C.

FIG. 3 shows a schematic cross-sectional view of a portion of a beamlet blanker array **9** provided with a cooling channel **94** that is part of the cooling arrangement **93.** The cooling channel **94** is arranged to accommodate a flow of a cooling fluid **96.** Preferably, the flow is a forced flow by an external source, i.e. coolant system **25** in FIG. 2, to obtain forced convection in the cooling channel **94.**

The cooling arrangement **93** is connected to the beamlet blanker array **9** by means of an adhesive layer **97.** Preferably, the adhesive being used in the adhesive layer **97** has a sufficiently high thermal conductivity to provide as much cooling capacity as possible. Preferably, the adhesive layer has a heat transfer coefficient greater than 100 kW/m²·K, more preferably greater than 150 kW/ m²·K.

Heat transfer via the cooling fluid within the cooling arrangement **93** improves the role of the arrangement **93** in removing heat away from the beamlet blanker array **9** so as to keep the beamlet blanker array **9** below a threshold temperature. The extent of heat transfer between a side wall **95** of the cooling channel **94** and the cooling fluid **96** can be indicated by a heat transfer coefficient. Experiments have shown that the heat transfer coefficient generally increases with the flow speed of cooling fluid **96** in the channel.

Another advantage of a relatively high flow speed of cooling fluid **96** in the channel **94** is that such speed reduces the temperature difference ΔT between the temperature of the cooling fluid at entry of the channel **94** and the temperature of the cooling fluid at the exit of the channel **94.** As a result, the heat absorbing capacity of the cooling fluid does not change significantly as a function of channel position, and cooling can be effected in a more homogeneous way.

However, for some components within a lithography system, requirements regarding cooling are of somewhat less importance than requirements with respect to other parameters, such as vibrational influences. For such components, it may be preferable to have a relatively low speed. In some embodiments, the flow speed may be such that the fluid flow is a laminar flow. The use of a laminar flow reduces the generation of vibrations caused by interaction between the cooling fluid **96** and the cooling arrangement **93.** Furthermore, the corrosion erosion is much lower for a laminar flow than for a turbulent flow.

As far as cooling is concerned, a turbulent flow is more preferable than a laminar flow. In a truly laminar flow, there is no flow component perpendicular to the channels walls, so any heat transfer in that direction occurs solely via much less efficient conduction in the cooling fluid. However, in a turbulent flow heat will be transferred in a direction perpendicular to the channel walls. Consequently, the cooling fluid can absorb more heat.

Considering the limitations of the geometries involved, convection is the ideal mechanism to transfer heat away from the optical component in an effective way. Although conductive heat transfer will always occur to some extent, convective heat transfer is generally dominant.

Furthermore, the cooling arrangement **93** is preferably made of a material that has a coefficient of thermal expansion (CTE) that is similar, or at least not too different, from the CTE of the beamlet blanker array material. A too large difference in CTE between the cooling arrangement material and the beamlet blanker array material may cause deformation of the beamlet blanker array. Furthermore, the adhesive layer preferably has a CTE that is not too different as well to ensure that the cooling arrangement **93** and the beamlet blanker array **9** remain at substantially the same position with respect to each other in case the beamlet blanker array expands due to exposure to heat originating from impingement of charged particles on its source surface side. Furthermore, the beamlet blanker array **9** may expand as a result of heat used in circuitry within the non-beam areas.

**Table 1 CTE of different materials**

| **Material** | **CTE [µm/m·K]** |
|---|---|
| Silicon | 2.6 |
| Tungsten / AlN | 4.5 |
| Titanium | 8.6 |
| Copper | 16.5 |

Table 1 illustrates CTEs of different materials. In many embodiments, the beamlet blanker array material will be silicon. As follows from Table 1, silicon has a CTE of 2.6 µm/m·K. Typical materials for a cooling arrangement **93** would be copper (Cu), tungsten (W), aluminum nitride (AlN) and titanium (Ti). As follows from Table 1, of these materials copper is the least suitable to be used for a cooling arrangement that is provided on a silicon beamlet blanker array, because the CTE of copper is by far the highest, i.e. 16.5 µm/m·K.\

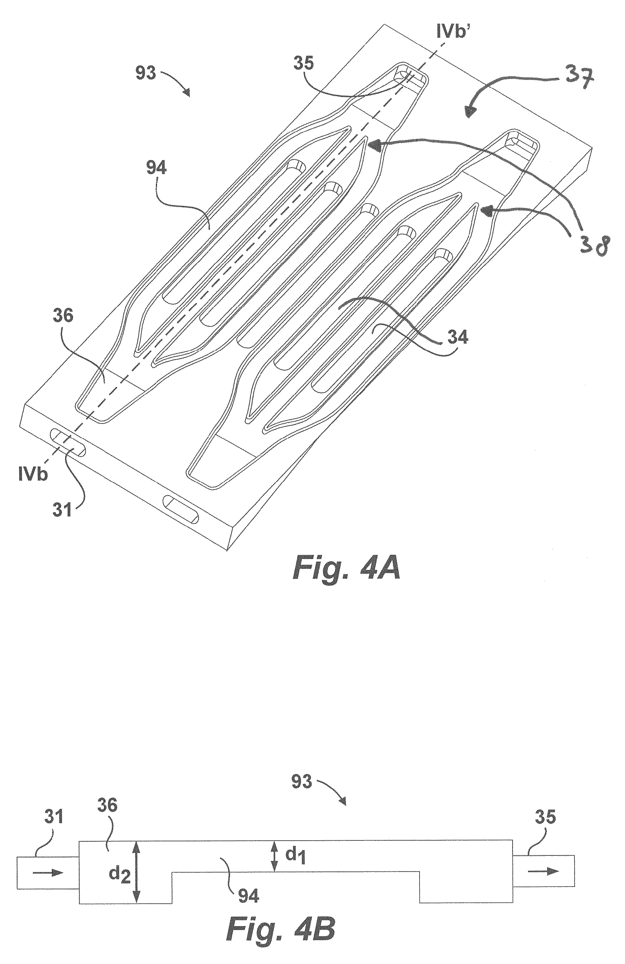

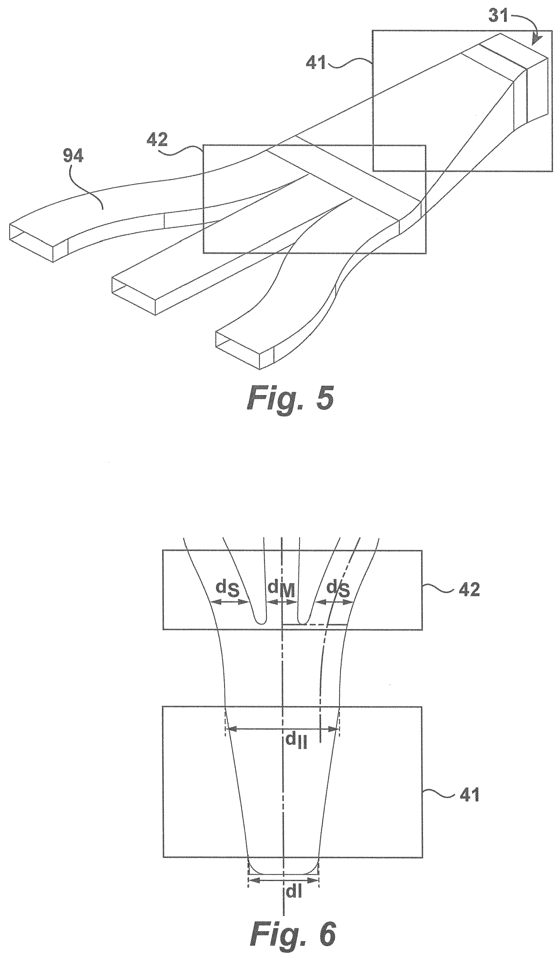

FIG. 4A shows an elevated cross-sectional top view of the cooling arrangement **93** without cooling fluid flowing there through. The cooling channels **94** in the cooling arrangement **93** are generally closed cooling channels, i.e. channels entirely surrounded by side walls along their length. In FIG. 4A, a cover for covering the different components of the cooling arrangement, for example to serve as a side wall for cooling channels **94,** is not shown for clarity reasons. Such cover prevents that cooling fluid can leak out of the cooling arrangement **93.** The cooling arrangement **93** comprises a flat surface **37** for connecting to the plate with apertures to allow the flat surface **37** to function as a heat transfer surface. The cooling arrangement **93** is provided on the surface side **37** with two cut-out volumes in accordance with the lay-out of the cooling channels **94.** The perimeters for the cut-out volumes define cut-out apertures **38.** The cooling arrangement **93** is provided with one or more inlets **31** for receipt of cooling fluid and one or more outlets **35** for removal of cooling fluid. The cooling fluid flows from the one or more inlets **31** towards the one or more outlets **35** through a cooling channels **94** while capturing heat along the way. Preferably, the number of cooling channels **94** exceeds the number of inlets **31** and outlets **35.** Further details with respect to this design will be discussed with reference to FIGS. 5 and 6.

To avoid that the cooling arrangement **93** interferes with the charged particle beamlets, the cooling arrangement **93** is provided with slots **34** that are positioned over beam areas of the beamlet blanker array **9.** By suitably aligning the slots **34** with respect to the beam areas of the blanker array **9** the cooling arrangement may cover and be in contact with the blanker array over most, preferably all, surface area reserved for the non-beam areas.

FIG. 4B is a cross-sectional view of the cooling arrangement **93** depicted in FIG. 4A along the line IVb - IVb'. Preferably, the cooling arrangement **93** does not occupy too much space. Preferably, the cooling arrangement **93** should not interfere with the optimal position of other components within the electron optical column. That is, in many cases the height of the cooling arrangement is restricted so to avoid that an adjacent component in the electron optical column, i.e. a component upstream if the cooling arrangement is arranged at the source side of the blanker array **9** or a component downstream if the cooling arrangement is arranged at the target side of the blanker array **9,** can not be positioned at its desired position. That is, electron optical components in the electron optical column are generally placed in such a way that their influence on the charged particle beamlets is optimal for the electron optical performance of the column. For example, in the embodiment shown in FIG. 2, the dimensions of the cooling arrangement **93** are limited by the presence of the condenser lens array **20.**

In the embodiment shown in FIG. 4B, the height *d₁* of the cooling channels **94** on top of the beamlet blanker array **9** is limited in view of abovementioned reason. However, because there may be more space available at the side of the beamlet blanker array **9** the height *d₂* of cooling channel or reservoir **36** connected to the inlet **31** may be higher. A similar height *d₂* may be used in a cooling channel or reservoir connected to the outlet **35.** The use of a greater height *d₂* at locations where such space is available has the advantage that a sufficient amount of cooling fluid can be provided and/or removed. At the same time, the presence of multiple cooling channels of limited height ensures that the beamlet blanker array can be sufficiently cooled. Exemplary dimensions for heights *d₁* and *d₂* are 1-3 mm, e.g. 1.7 mm, and 3-10 mm, e.g. 4.0 mm, respectively.

FIG. 5 shows a portion of the cooling fluid channel lay-out according to an embodiment of the invention. The inlet **31** is connected to the plurality of cooling channels **94** via a single distribution channel or tube. **The** single distribution channel comprises a diffuser section **41** for diffusing cooling fluid and a splitting section **42** for dividing the cooling fluid over the plurality of cooling channels **94.** Dividing the cooling fluid flow over multiple channels **94** allows to spread resistance caused by a turbulent fluid flow.

FIG. 6 shows a top view of the cooling fluid channel lay-out of FIG. 5. As can be seen in FIG. 5 the height of the cooling channel lay-out is higher at a position close to the inlet **31** than at a position close to the plurality of cooling channels **94.** As mentioned earlier, the space available for the cooling channels **94** may be limited. However, the fluid is preferably supplied at a velocity sufficiently high to create a turbulent flow through the cooling channels **94,** for example by using a coolant system **25** as depicted in FIG. 2.

To accommodate a fluid with a high velocity, preferably the cooling arrangement **93** is thicker at locations further away from beam areas, and the inlet **31** is then located in such thicker portion. The inlet **31** may then have a relatively large cross-sectional area. The diffuser section allows the fluid to diffuse in such a way that the flow can be spread as homogeneously as possible over the plurality of cooling channels within the splitting section **42.** The cross-sectional area of the flow path at entry of the diffuser section is preferably the same as the cross-sectional area of the flow path at the exit of the diffuser section exit. Such dimensioning ensures that the cooling fluid enters and exits the diffuser section **41** at substantially the same velocity. In FIG. 6, the dimensions may thus be such that for a rectangular cross-section *d_{I}* times the height at entry equals *d_{II}* times the height at the exit of the diffuser section.

In some embodiments, for example the embodiment with a layout as depicted in FIG. 6, the cross-sectional areas of the one or more channels being substantially aligned with the inlet have smaller dimensions than the cross-sectional areas of channels that are more offset with respect to the inlet. In FIG. 6, under the assumption that all channels have the same height, the center channel has a diameter *d_{M}* that is smaller than the diameter *d_{S}* of the side channels. The use of different cross-sectional areas may help to evenly spread fluid resistance over the multiple channels **94.**

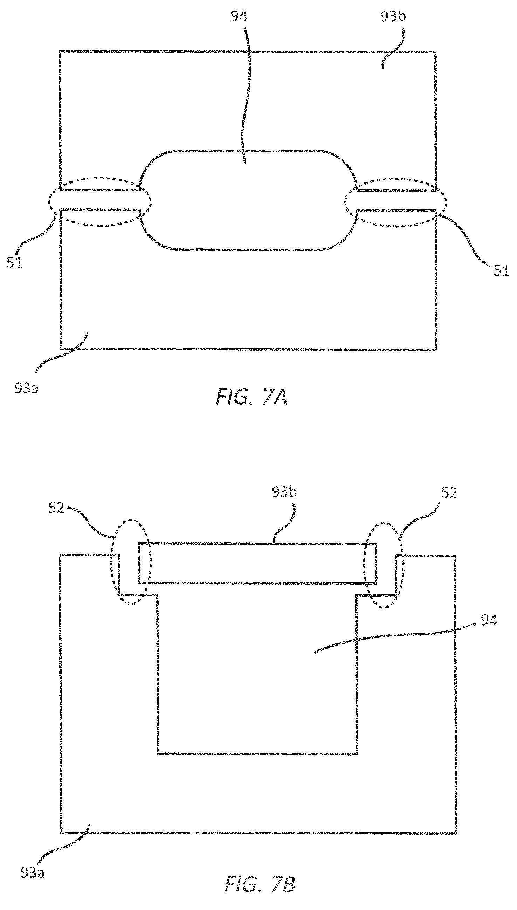

The cooling arrangement **93** is manufactured by assembling multiple bodies onto each other. The size and shape of the bodies may depend on the materials being used, the method of assembly and the dimensions at hand. FIGS. 7A, 7B schematically show cross-sectional views of a portion of the cooling arrangement **93,** in this case a channel **94** prior to assembly.

The cooling arrangement **93** of FIG. 7A is manufactured by assembling two bodies **93a, 93b** onto each other. Both bodies **93a, 93b** are shaped such that a significant portion of a channel is formed therein, in this case the cut-out area in each body **93a, 93b** contributes for about 50% to the channel(s) being formed. In the shown embodiment, the two bodies **93a, 93b** are connected to each other with an adhesive in areas **51.** Such assembly is effective if the bodies **93a, 93b** are made of AlN.

The cooling arrangement **93** of FIG. 7B is also manufactured by assembling two bodies **93a, 93b.** However, in this case the first body **93a** contributes primarily to the channel, while the second body **93b** only serves to close the channel. In this case, the second body **93b** may be connected to the first body **93a** by laser welding in area **52.** The area 52 is bounded by the edge of the cut-out aperture 38. Such assembly may be used if titanium is used as the cooling arrangement material.

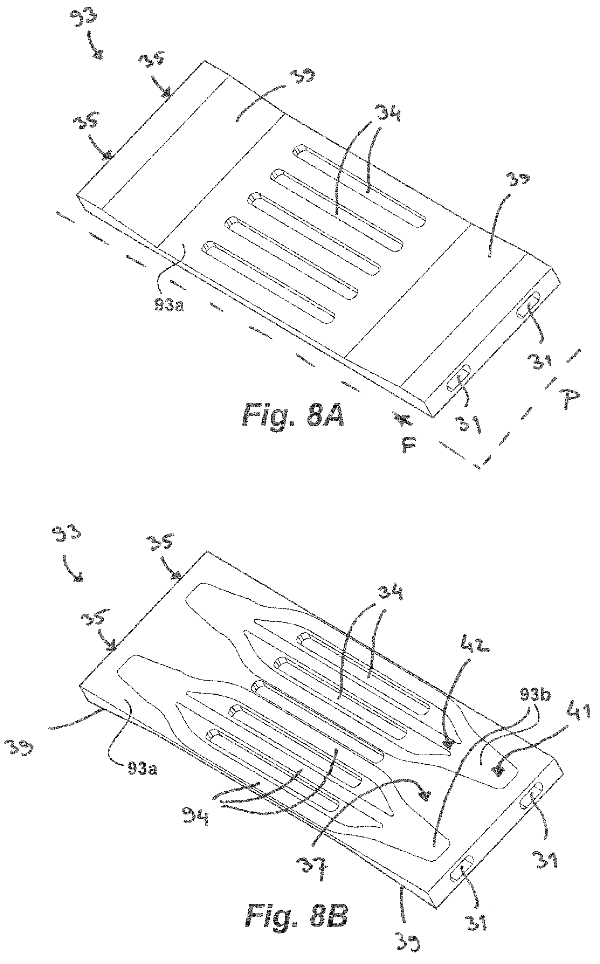

FIGS. 8A, 8B show an elevated bottom and top view of a cooling arrangement **93** according to an embodiment of the invention. In this embodiment, the cooling arrangement has been made in accordance with the assembly technique shown in FIG. 7B. This embodiment of the cooling arrangement **93,** which is similar to the embodiment described with reference to FIG.4A, is formed by a flat body provided with six cooling channels **94** that are separated by five slots **34.** These slots **34** are configured to be positioned over beam areas of the plate provided with apertures (e.g. the beamlet blanker array **9** or the beamlet stop array **10** of the lithography system) in such a manner that interference by the cooling arrangement **93** with charged particle beamlets is avoided. By suitably aligning the slots **34** with respect to the beam areas of the plate, the cooling arrangement **93** may cover and be in contact with the plate over most, preferably all, surface area that is reserved for the non-beam areas.

The cooling arrangement **93** in FIGS.8A and 8B may be manufactured by joining a first body **93a** with two second bodies **93b.** The first body is formed as a plate-shaped body **93a** provided with the six cooling channels **94** and the five slots **34.** The plate-shaped body **93a** is preferably made from titanium. The plate-shaped body **93a** comprises a flat surface **37** that spans a contact plane **P** for connecting to the plate with apertures, so as to allow the flat surface **37** to function as a heat transfer surface. The six cooling channels **94** are arranged coplanar and (substantially) mutually parallel to define a flow direction **F.** The plane spanned by the six cooling channels **94** is substantially parallel with the flat surface side **37** and thus with the contact plane **P.** Each cooling channel **94** is along at least one side thereof (as viewed in the flow direction **F)** bounded by one slot **34.** Each slot **34** has an elongate shape along the flow direction **F** i.e. parallel with the cooling channels **94.** The cooling arrangement **93** in FIGS.8A and 8B is provided with two inlets **31** for receiving cooling fluid into the cooling arrangement **93,** and two outlets **35** for discharging cooling fluid from the cooling arrangement **93.** During cooling operation, the cooling fluid flows from the two inlets **31** towards the two outlets **35** through the cooling channels **94,** while extracting thermal energy from the plate with apertures along the way. The cooling arrangement **93** is thicker at outer regions **39** of the plate shaped body **93a,** this thickness corresponding to a direction perpendicular to the contact plane **P.** The inlets **31** and the outlets **35** are located in the thicker outer regions **39,** and allow the inlets **31** and the outlets **35** to have cross-sectional areas that are larger than the cross-sectional areas of the cooling channels **94.** The inlets **31** and outlets **35** also run substantially parallel to the flow direction **F,** thereby minimizing any obstruction of the fluid flow. One inlet **31** is connected to three cooling channels **94** via a single distribution channel, which comprises a diffuser section **41** and a splitting section **42** as was described with reference to FIGS.5 and 6. The outlet **35** is similarly provided with a three-way distribution channel. In the resulting channel lay-out, the distribution channel of each of the two inlets **31** splits up into three cooling channels **94,** and these three cooling channels **94** subsequently merge back into the distribution channel of one of the two outlets **35.** The channel lay-out in this cooling arrangement **93** may be used in similar cooling arrangements having n x 3 (n = 1, 2, 3,..) cooling channels **94,** and n inlets **31** and outlets **35.**

The plate-shaped body **93a** with the two inlets **31** and the two outlets **35** is provided entirely on one side of the contact plane **P** (i.e. in the first half space). As a result, the flat surface side 37 can be attached at the other side of the contact plane **P** (i.e. in the other half space) as a heat transfer surface to any desired portion of the plate with apertures in the lithography system (e.g. the beamlet blanker array **9** or the beamlet stop array **10),** without obstruction by any other portion of the cooling arrangement **93.**

The plate-shaped body may be obtained by providing the first body **93a** on the surface side **37** with two cut-out volumes in accordance with the lay-out of the cooling channels **94.** A perimeter of each cut-out volume near the surface side **37** defines a cut-out aperture **38** (see FIG.4A). The resulting two cut-out apertures **38** are covered by the second bodies **93b,** which are formed by cover plates that each has a shape which is similar to the cut-out apertures **38,** and which is arranged to cover the cut-out volume flush with the flat surface side **37.** The two cover plates **93b** are positioned over the two cut-out apertures **38,** so as to form the cooling channels **94** in accordance with the assembly technique illustrated by FIG. 7B. The cooling channels **94** may thus be formed to define a channel lay-out with rectangular cross-sections (viewed perpendicular to the flow direction **F).** The described assembly technique is particularly suitable for manufacturing this rectangular channel layout. The cover plates **93b** may be connected to the first body **93a** by laser welding the respective cover plate **93b** along the contour of the corresponding cut-out aperture **38.** The cover plates **93b** are preferably also made from titanium. The technique of providing the cut-out volumes in the plate shaped body **93a** and covering the cut-out volumes with the cover plates **93b** on the flat surface side **37** yields an optimal balance between good heat transfer properties on the one hand and good manufacturing accuracy on the other hand. This applies in particular for cooling arrangements **93** having dimensions in the order of several (tens of) millimeters (e.g. the values for *d₁* and *d₂* described herein above). Typical lengths for the cooling channels **94** and the slots 34 (viewed along the flow direction **F)** may for example be in the range of 25 millimeters to 50 millimeters, preferably 37 millimeters. Typical external widths of the cooling channels **94** (transversal to the flow direction **F)** may be 3 millimeters to 4 millimeters, preferably 3.5 millimeters, and typical internal widths of the cooling channels **94** may be 2 millimeters to 3 millimeters, preferably 2.5 millimeters. Typical widths of the slots **34** may be 2 millimeters to 3 millimeters, preferably 2.5 millimeters.

FIGS. 9A, 9B show an elevated top and bottom view of another cooling arrangement **93'** according to an embodiment of the invention. The cooling arrangement **93'** also includes a plurality of cooling channels **94** connecting an inlet **31** with an outlet **35.** However, in this embodiment the cooling channels **94** in the cooling arrangement **93'** have an open structure, as is shown in FIG. 9B.

The cooling arrangement **93'** comprises a distribution channel **43** connecting the inlet **31** with the plurality of cooling channels **94,** the distribution channel **43** being arranged for receiving the cooling fluid **31** from the inlet **31,** for example supplied via a coolant system **25,** and guiding the cooling fluid in such a way that the cooling fluid is transferred through the cooling channels **94** in a laminar flow regime. As a result of the laminar flow, the cooling fluid may have a negligible influence on the structure to be cooled with respect to vibrations.

The inlet **31** and the outlet **35** are preferably placed diagonally with respect to the orientation of the cooling channels **94** between the beam areas to reduce cooling inhomogeneity as a function of location caused by a somewhat higher temperature difference between the cooling fluid at cooling channel entry and the cooling fluid at cooling channel exit as compared to such temperature difference in case of a high-speed, turbulent flow.

FIGS. 10A, 10B show an elevated top and bottom of the cooling arrangement **93'** of FIGS. 9A, 9B disposed on a beamlet stop array **10.** By attaching the beamlet stop array **10** directly onto the cooling arrangement **93',** the cooling channels **94** are closed, and leakage of cooling fluid out of the combination of the cooling arrangement **93'** and the beamlet stop array **10** may be avoided. The cooling arrangement **93'** may in particular also be useful to cool vibrationally sensitive components within a lithography system, for example a critical lens plate of a projection lens array in a beamlet projector.

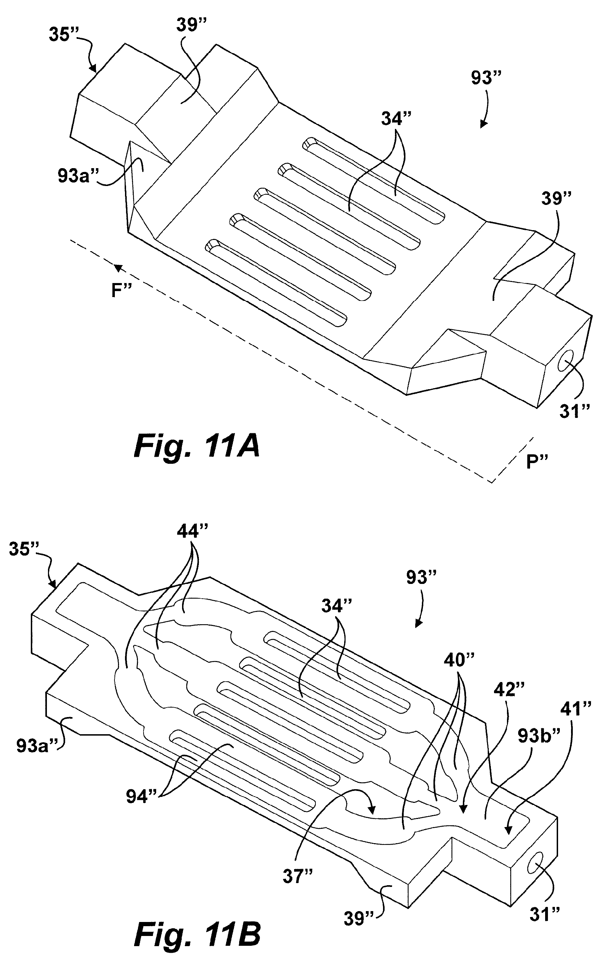

FIGS. 11A and 11B show an elevated bottom and top view of another cooling arrangement **93"** according to embodiment of the invention. The cooling arrangement **93"** represents an alternative to the embodiment described with reference to FIGS.8A and 8B, and a majority of features in the cooling arrangement 93 described there may also be present in the cooling arrangement **93"** shown in FIGS.11A and 11B. These features will not be discussed here again. For the features that are discussed here, similar reference numbers are used for similar features, but indicated by primes to distinguish the embodiments.

The cooling arrangement **93"** is again formed by a flat body provided with six cooling channels **94"** that are separated by five slots **34"** configured for positioning over plate beam areas. In this case, the cooling arrangement **93"** is provided with a single inlet **31"** for receiving of cooling fluid, and a single outlet **35"** for discharging the cooling fluid. During operation, the cooling fluid flows from the inlet **31"** towards the outlet 35" through the six cooling channels **94"** along flow direction **F".** The cooling fluid flowing through the cooling channels **94"** may collect thermal energy along the way that may for example originate from a hot planar object that is connected to the flat surface side 37" along the contact plane **P".** Again, the cooling arrangement **93"** is thicker at outer regions **39"** of the plate-shaped body **93a",** and the inlet **31"** and the outlet **35"** are located in these thicker outer regions **39".** The inlet **31"** is connected to the six cooling channels **94"** via a two-staged distribution channel. The two-staged distribution channel of the inlet **31"** comprises a diffuser section **(41")** for diffusing cooling fluid, and a splitting section **(42")** for dividing the cooling fluid over the cooling channels **94",** these sections being similar to the ones in the distribution channel as described herein above with reference to FIGS.5 and 6. In the splitting section, the inlet channel **31"** initially branches off into three channels that each comprises a divergent section **40".** These divergent sections **40"** preferably diverge (i.e. increase the channel cross-section perpendicular to the flow direction while proceeding along the flow direction) with a smooth lateral curvature, to expand the respective channel and generate a gradual decrease in the flow velocity. The expanded portions of the channels are formed analogous to what has been explained with reference to FIG.6 i.e. the middle initial channel (which is substantially aligned with the inlet **31)** has a smaller cross-sectional area than the cross-sectional areas of the outer initial channels (which are more offset with respect to the inlet **31).** Each channel subsequently splits up into two adjacent cooling channels **94"** that are laterally separated by a slot **34".** At the other end of the slots **34"** (viewed along the flow direction **F"),** each of the adjacent pairs of cooling channels **94"** subsequently merges back into a further channel. Each of the three further channels comprises a convergent section **44",** which is preferably formed by a smooth lateral narrowing of the channel. The three further channels join into the outlet channel **35"** by means of a two-staged distribution channel complementary to the one provided at the inlet **31".**

The plate-shaped body **93a"** may be obtained by providing a single cut-out volume in accordance with a lay-out of the six cooling channels **94"** on the flat surface side 37", and may also be manufactured in accordance with the technique illustrated by FIG.7B. A perimeter of the cut-out volume near the surface side **37"** defines a single cut-out aperture. The resulting cut-out aperture is covered by a cover plate **93b"** that has a shape matching the contour of the cut-out aperture, in such a manner that the cover plate **93b"** can be positioned flush with the flat surface side **37".** This cooling channel **94"** lay-out requires only a single cut-out volume, and allows connection to single conduits for the supply and discharge of cooling fluid. The channel lay-out in this cooling arrangement **93"** is particularly suitable for application in similar cooling arrangements having n x 6 (n = 1, 2, 3, ...) cooling channels **94",** and n inlets **31"** and outlets **35".** Preferably, the inlet **31"** and the outlet **35"** each have a cross-sectional area that equals the sum of the cross-sectional areas of the cooling channels **94".**

The invention has been described by reference to certain embodiments discussed above. It will be recognized that these embodiments are susceptible to various modifications and alternative forms well known to those of skill in the art without departing from the scope of the invention. Accordingly, although specific embodiments have been described, these are examples only and are not limiting upon the scope of the invention, which is defined in the accompanying claims.

## Claims

1. A charged particle multi-beamlet lithography system (1) for exposing a target (13) using a plurality of charged particle beamlets (7), the system comprising:
- a beamlet generator (2) for generating the charged particle beamlets;
- a beamlet modulator (8) for patterning the beamlets to form modulated beamlets;
- a beamlet projector (12) for projecting the modulated beamlets onto a surface of the target;
wherein the beamlet generator, beamlet modulator and/or beamlet projector comprise one or more plates provided with a plurality of apertures for letting the beamlets pass through the plate, the apertures being arranged in groups to form on the surface of the one or more plates a plurality of beam areas (91) distinct and separate from a plurality of non-beam areas (92) containing no apertures for passage of the beamlets; and
wherein at least one of the plates with apertures in the lithography system is provided with a cooling arrangement (93) disposed on its surface in one or more non-beam areas, the cooling arrangement comprising a plate-shaped body provided with an inlet (31) for receiving a cooling liquid, a plurality of cooling channels (94) arranged for flow of a cooling liquid therein, and an outlet (35) for removing the cooling liquid, wherein the plate-shaped body is provided with a plurality of slots (34) between the cooling channels, and wherein the slots are substantially aligned with the beam areas on the aperture plate surface; and **characterised in that** the inlet and the plurality of cooling channels are connected to each other via a single distribution channel, the single distribution channel comprising a diffuser section (41) for diffusing cooling liquid and a splitting section (42) for dividing the cooling liquid over the plurality of cooling channels (94).

2. The system of claim 1, wherein the diffuser section has a first cross-sectional area at a side facing the inlet (31) and a second cross-sectional area facing the plurality of cooling channels;
wherein the first cross-sectional area and the second cross-sectional area are equal; and wherein the height of the first cross-sectional area is greater than the height of the second cross-sectional area, the height in a direction perpendicular to a planar portion of the plate-shaped body through which the cooling channels run.

3. The system of claim 1 or 2, wherein the plate-shaped body comprises a flat surface (37) that spans a contact plane (P) for connecting to the plate provided with apertures, wherein the cooling channels (94) are mutually arranged substantially parallel to define a flow direction (F) that is substantially parallel to the contact plane (P).

4. The system of any one of the preceding claims, wherein the plate-shaped body of the cooling arrangement is connected to the at least one plate provided with apertures by means of an adhesive layer (97), said adhesive layer (97) preferably having an overall heat transfer coefficient greater than 100 kW/m²·K, preferably greater than 150 kW/ m²·K.

5. The system of any one of the preceding claims, further comprising a coolant system (25) arranged to provide cooling liquid to the inlet of the cooling arrangement at a sufficiently high flow speed to produce a turbulent flow of cooling liquid through the plurality of cooling channels.

6. The system of any one of the preceding claims, wherein the beamlet modulator comprises a beamlet blanker array (9) and a beamlet stop array (10), and wherein the plate-shaped body of the cooling arrangement is disposed on a surface of the beamlet blanker array.

7. The system of any one of claims 1-4, further comprising a coolant system (25) for providing cooling liquid to the inlet of the cooling arrangement at a sufficiently low flow speed to produce a laminar flow of cooling liquid through the plurality of cooling channels, preferably wherein the beamlet modulator comprises a beamlet blanker array (9) and a beamlet stop array (10), and wherein the plate-shaped body of the cooling arrangement is disposed on a surface of the beamlet stop array.

8. The system of claim 7, wherein the plate-shaped body of the cooling arrangement is disposed on a surface of an aperture plate of the beamlet projector.

9. The system according to any one of the preceding claims, wherein the cooling liquid comprises water.

10. The system according to any one of the preceding claims, wherein the plate-shaped body of the cooling arrangement is made of titanium.

11. Method of manufacturing a cooling body for use on top of a surface of a plate provided with a plurality of apertures for use in a multi-beamlet charged particle lithography system, the apertures being arranged in groups to form a plurality of beam areas (91) on the surface of the plate, the method comprising:
- providing a plate-shaped body, a surface side (37) of the body being provided with a cut-out volume in accordance with a lay-out;
- providing a plurality of slots (34) in the plate-shaped body, wherein the slots are arranged to be aligned with the beam areas on the aperture plate surface;
- covering the cut-out volume so as to form a plurality of cooling channels (94) within the body, wherein the slots (34) are arranged between the cooling channels (94), the plurality of cooling channels connecting an inlet at a side of the body with an outlet at another side of the body.

12. Method of claim 11, wherein covering includes connecting one or more cover plates on the body by means of laser welding.

13. Method of claim 11 or 12, wherein the body is made of titanium.

14. Method of claim 11, wherein covering includes adhering the aperture plate to be cooled onto the body.

15. Method of manufacturing a cooling body for use on top of a surface of a plate provided with a plurality of apertures for use in a multi-beamlet charged particle lithography system, the apertures being arranged in groups to form a plurality of beam areas (91) on the surface of the plate, the method comprising:
- providing a first plate-shaped body, a surface side of the first body being provided with a first cut-out volume in accordance with a first lay-out;
- providing a second plate-shaped body, a surface side of the second body being provided with a second cut-out volume in accordance with a second lay-out;
- providing a plurality of slots (34) in the first and second plate-shaped bodies, wherein the slots are arranged to be aligned with the beam areas on the aperture plate surface, and
- connecting the surfaces of the first body and the second body onto each other such that the first cut-out volume and the second cut-out volume form a plurality of cooling channels within an assembled body, wherein the slots (34) are arranged between the cooling channels (94), the plurality of cooling channels connecting an inlet at a side of the assembled body with an outlet at another side of the assembled body,
preferably wherein connecting is performed by providing an adhesive layer between the surfaces of the first body and the second body.

## Patentansprüche

1. Lithographiesystem (1) mit mehreren Beamlets geladener Teilchen zum Belichten eines Ziels (13) unter Verwendung von Beamlets (7) geladener Teilchen, wobei das System
- einen Beamletgenerator (2) zur Erzeugung der Beamlets geladener Teilchen;
- einen Beamletmodulator (8) zum Mustern der Beamlets, um modulierte Beamlets zu bilden;
- einen Beamletprojektor (12) zum Projizieren der modulierten Beamlets auf eine Fläche des Ziels
umfasst;
wobei der Beamletgenerator, der Beamletmodulator und/oder der Beamletprojektor eine oder mehrere Platten umfasst, die mit mehreren Öffnungen versehen ist bzw. sind, um die Beamlets durch die Platte verlaufen zu lassen, wobei die Öffnungen in Gruppen angeordnet sind, um an der Fläche der einen oder der mehreren Platten mehrere Strahlbereiche (91) zu bilden, die von mehreren Nichtstrahlbereichen (92), welche keine Öffnungen für den Durchgang der Beamlets enthalten, abgegrenzt und getrennt sind; und
wobei wenigstens eine der Platten mit Öffnungen in dem Lithographiesystem mit einer Kühlanordnung (93) versehen ist, die in einem oder mehreren Nichtstrahlbereichen an ihrer Fläche angeordnet ist, wobei die Kühlanordnung einen plattenförmigen Körper umfasst, der mit einem Einlass (31) zum Erhalt einer Kühlflüssigkeit, mehreren Kühlkanälen (94), die für den Fluss einer Kühlflüssigkeit in ihrem Inneren bereitgestellt sind, und einem Auslass (35) zur Beseitigung der Kühlflüssigkeit versehen ist, wobei der plattenförmige Körper mit mehreren Schlitzen (34) zwischen den Kühlkanälen versehen ist, und wobei die Schlitze im Wesentlichen mit den Strahlbereichen an der Öffnungsplattenfläche ausgerichtet sind; und **dadurch gekennzeichnet, dass**
der Einlass und die mehreren Kühlkanäle miteinander über einen einzelnen Verteilungskanal verbunden sind, wobei der einzelne Verteilungskanal einen Diffusorabschnitt (41) zum Diffundieren von Kühlflüssigkeit und einen Aufteilabschnitt (42) zum Verteilen der Kühlflüssigkeit über die mehreren Kühlkanäle (94) umfasst.

2. System nach Anspruch 1, wobei der Diffusorabschnitt an einer Seite, die zu dem Einlass (31) gewandt ist, eine erste Querschnittfläche aufweist, und zu den mehreren Kühlkanälen gewandt eine zweite Querschnittfläche aufweist;
wobei die erste Querschnittfläche und die zweite Querschnittfläche gleich sind; und
wobei die Höhe der ersten Querschnittfläche größer als die Höhe der zweiten Querschnittfläche ist, wobei die Höhe in einer Richtung verläuft, die sich senkrecht zu einem flachen Abschnitt des plattenförmigen Körpers, durch den die Kühlkanäle verlaufen, erstreckt.

3. System nach Anspruch 1 oder 2, wobei der plattenförmige Körper eine flache Fläche (37) umfasst, die eine Kontaktebene (P) zur Verbindung mit der Platte, die mit Öffnungen versehen ist, überspannt,
wobei die Kühlkanäle (94) untereinander im Wesentlichen parallel angeordnet sind, um eine Fließrichtung (F) zu definieren, die im Wesentlichen parallel zu der Kontaktebene (P) verläuft.

4. System nach einem der vorhergehenden Ansprüche, wobei der plattenförmige Körper der Kühlanordnung durch eine Klebstoffschicht (97) mit der wenigstens einen Platte, die mit Öffnungen versehen ist, verbunden ist, wobei die Klebstoffschicht (97) vorzugsweise einen gesamten Wärmeübergangskoeffizienten von mehr als 100 kW/m²□K und vorzugsweise mehr als 150 kW/m²□K aufweist.

5. System nach einem der vorhergehenden Ansprüche, ferner umfassend ein Kühlmittelsystem (25), das eingerichtet ist, um dem Einlass der Kühlanordnung eine Kühlflüssigkeit mit einer ausreichend hohen Fließgeschwindigkeit bereitzustellen, um eine Wirbelströmung der Kühlflüssigkeit durch die mehreren Kühlkanäle zu erzeugen.

6. System nach einem der vorhergehenden Ansprüche, wobei der Beamletmodulator eine Beamletaustastanordnung (9) und eine Beamletanhalteanordnung (10) umfasst, und wobei der plattenförmige Körper der Kühlanordnung an einer Fläche der Beamletaustastanordnung angeordnet ist.

7. System nach einem der Ansprüche 1 bis 4, ferner umfassend ein Kühlmittelsystem (25), um dem Einlass der Kühlanordnung eine Kühlflüssigkeit mit einer ausreichend geringen Fließgeschwindigkeit bereitzustellen, um eine laminare Strömung der Kühlflüssigkeit durch die mehreren Kühlkanäle zu erzeugen, wobei vorzugsweise der Beamletmodulator eine Beamletaustastanordnung (9) und eine Beamletanhalteanordnung (10) umfasst, und wobei der plattenförmige Körper der Kühlanordnung an einer Fläche der Beamletanhalteanordnung angeordnet ist.

8. System nach Anspruch 7, wobei der plattenförmige Körper der Kühlanordnung an einer Fläche einer Öffnungsplatte des Beamletprojektors angeordnet ist.

9. System nach einem der vorhergehenden Ansprüche, wobei die Kühlflüssigkeit Wasser umfasst.

10. System nach einem der vorhergehenden Ansprüche, wobei der plattenförmige Körper der Kühlanordnung aus Titan besteht.

11. Verfahren zur Herstellung eines Kühlkörpers zur Verwendung an der Oberseite einer mit mehreren Öffnungen versehenen Fläche einer Platte zur Verwendung in einem Lithographiesystem mit mehreren Beamlets geladener Teilchen, wobei die Öffnungen in Gruppen angeordnet sind, um an der Fläche der Platte mehrere Strahlbereiche (91) zu bilden, wobei das Verfahren umfasst:
- Bereitstellen eines plattenförmigen Körpers, wobei eine Flächenseite (37) des Körpers mit einem ausgeschnittenen Volumen gemäß einer Anordnung versehen ist;
- Bereitstellen mehrerer Schlitze (34) in dem plattenförmigen Körper, wobei die Schlitze so angeordnet sind, dass sie mit den Strahlbereichen an der Öffnungsplattenfläche ausgerichtet sind;
- derartiges Abdecken des ausgeschnittenen Volumens, dass in dem Körper mehrere Kühlkanäle (94) gebildet werden, wobei die Schlitze (34) zwischen den Kühlkanälen (94) angeordnet sind, wobei die mehreren Kühlkanäle einen Einlass an einer Seite des Körpers mit einem Auslass an einer anderen Seite des Körpers verbinden.

12. Verfahren nach Anspruch 11, wobei das Abdecken ein Verbinden einer oder mehrerer Abdeckplatten durch Laserschweißen mit dem Körper umfasst.

13. Verfahren nach Anspruch 11 oder 12, wobei der Körper aus Titan besteht.

14. Verfahren nach Anspruch 11, wobei das Abdecken ein Kleben der Öffnungsplatte, die gekühlt werden soll, an den Körper umfasst.

15. Verfahren zur Herstellung eines Kühlkörpers zur Verwendung an der Oberseite einer mit mehreren Öffnungen versehenen Fläche einer Platte zur Verwendung in einem Lithographiesystem mit mehreren Beamlets geladener Teilchen, wobei die Öffnungen in Gruppen angeordnet sind, um an der Fläche der Platte mehrere Strahlbereiche (91) zu bilden, wobei das Verfahren umfasst:
- Bereitstellen eines ersten plattenförmigen Körpers, wobei eine Flächenseite des ersten Körpers mit einem ersten ausgeschnittenen Volumen gemäß einer ersten Anordnung versehen ist;
- Bereitstellen eines zweiten plattenförmigen Körpers, wobei eine Flächenseite des zweiten Körpers mit einem zweiten ausgeschnittenen Volumen gemäß einer zweiten Anordnung versehen ist;
- Bereitstellen mehrerer Schlitze (34) in dem ersten und dem zweiten plattenförmigen Körper, wobei die Schlitze so angeordnet sind, dass sie mit den Strahlbereichen an der Öffnungsplattenfläche ausgerichtet sind; und
- derartiges Verbinden der Flächen des ersten Körpers und des zweiten Körpers übereinander, dass das erste ausgeschnittene Volumen und das zweite ausgeschnittene Volumen in einem zusammengesetzten Körper mehrere Kühlkanäle bilden, wobei die Schlitze (34) zwischen den Kühlkanälen (94) angeordnet sind, wobei die mehreren Kühlkanäle einen Einlass an einer Seite des zusammengesetzten Körpers mit einem Auslass an einer anderen Seite des zusammengesetzten Körpers verbinden,
wobei das Verbinden vorzugsweise durch Bereitstellen einer Klebstoffschicht zwischen den Flächen des ersten Körpers und des zweiten Körpers durchgeführt wird.

## Revendications

1. Système de lithographie par petits faisceaux multiples à particules chargées (1) pour exposer une cible (13) en utilisant une pluralité de petits faisceaux à particules chargées (7), le système comprenant:
- un générateur de petits faisceaux (2) pour générer les petits faisceaux à particules chargées;
- un modulateur de petits faisceaux (8) pour modeler les petits faisceaux afin de former des petits faisceaux modulés;
- un projecteur de petits faisceaux (12) pour projeter les petits faisceaux modulés sur une surface de la cible;
dans lequel le générateur de petits faisceaux, le modulateur de petits faisceaux et/ou le projecteur de petits faisceaux comprennent une ou plusieurs plaques pourvues d'une pluralité d'ouvertures pour laisser les petits faisceaux passer à travers la plaque, les ouvertures étant disposées en groupes pour former sur la surface d'une ou plusieurs plaques une pluralité de zones de faisceau (91) distinctes et séparées d'une pluralité de zones de non faisceau (92) ne contenant pas d'ouverture pour le passage des petits faisceaux; et
dans lequel au moins une des plaques avec les ouvertures dans le système de lithographie est pourvue d'un agencement de refroidissement (93) disposé sur sa surface dans une ou plusieurs zones de non faisceau, l'agencement de refroidissement comprenant un corps en forme de plaque pourvu d'une entrée (31) pour recevoir un liquide de refroidissement, une pluralité de canaux de refroidissement (94) agencés pour l'écoulement du liquide de refroidissement dans ceux-ci et une sortie (35) pour enlever le liquide de refroidissement, dans lequel le corps en forme de plaque est pourvu d'une pluralité de fentes (34) entre les canaux de refroidissement, et dans lequel les fentes sont substantiellement alignées avec les zones de faisceau sur la surface de plaque d'ouverture; et **caractérisé en ce que**
l'entrée et la pluralité de canaux de refroidissement sont raccordés les uns aux autres via un canal de distribution unique, le canal de distribution unique comprenant une section de diffuseur (41) pour diffuser un liquide de refroidissement et une section de division (42) pour diviser le liquide de refroidissement sur la pluralité de canaux de refroidissement (94).

2. Système selon la revendication 1, dans lequel la section de diffuseur a une première zone de section transversale au niveau d'un côté faisant face à l'entrée (31) et une seconde zone de section transversale faisant face à la pluralité de canaux de refroidissement;
dans lequel la première zone de section transversale et la seconde zone de section transversale sont égales; et dans lequel la hauteur de la première zone de section transversale est supérieure à la hauteur de la seconde zone de section transversale, la hauteur dans une direction perpendiculaire à une portion planaire du corps en forme de plaque à travers lequel les canaux de refroidissement s'étendent.

3. Système selon la revendication 1 ou 2, dans lequel le corps en forme de plaque comprend une surface plate (37) qui définit un plan de contact (P) pour raccorder à la plaque pourvue d'ouvertures, dans lequel les canaux de refroidissement (94) sont réciproquement agencés substantiellement parallèlement afin de définir une direction d'écoulement (F) qui est substantiellement parallèle au plan de contact. (P).

4. Système selon une quelconque des revendications précédentes, dans lequel le corps en forme de plaque de l'agencement de refroidissement est raccordé à au moins une plaque pourvue d'ouvertures au moyen d'une couche adhésive (97), ladite couche adhésive (97) ayant de préférence un coefficient de transfert thermique total supérieur à 100 kW/m²□K, de préférence supérieur à 150 kW/m²□K.

5. Système selon une quelconque des revendications précédentes, comprenant en outre un système de liquide de refroidissement (25) agencé pour fournir un liquide de refroidissement à l'entrée de l'agencement de refroidissement à une vitesse d'écoulement suffisamment élevée pour produire un écoulement turbulent du liquide de refroidissement à travers la pluralité de canaux de refroidissement.

6. Système selon une quelconque des revendications précédentes, dans lequel le modulateur de petits faisceaux comprend un réseau d'occultation de petits faisceaux (9) et un réseau d'arrêt de petits faisceaux (10) et dans lequel le corps en forme de plaque de l'agencement de refroidissement est disposé sur une surface du réseau d'occultation de petits faisceaux.

7. Système selon une quelconque des revendications 1-4, comprenant en outre un système de liquide de refroidissement (25) pour fournir un liquide de refroidissement à l'entrée de l'agencement de refroidissement à une vitesse d'écoulement suffisamment basse pour produire un écoulement laminaire de liquide de refroidissement à travers la pluralité de canaux de refroidissement, de préférence dans lequel le modulateur de petits faisceaux comprend un réseau d'occultation de petits faisceaux (9) et un réseau d'arrêt de petits faisceaux (10), et dans lequel le corps en forme de plaque de l'agencement de refroidissement est disposé sur une surface du réseau d'arrêt de petits faisceaux.

8. Système selon la revendication 7, dans lequel le corps en forme de plaque de l'agencement de refroidissement est disposé sur une surface de plaque à ouverture du projecteur de petits faisceaux.

9. Système selon une quelconque des revendications précédentes, dans lequel le liquide de refroidissement comprend de l'eau.

10. Système selon une quelconque des revendications précédentes, dans lequel le corps en forme de plaque de l'agencement de refroidissement est fabriqué en titane.

11. Procédé de fabrication d'un corps de refroidissement à utiliser au sommet d'une surface d'une plaque pourvue d'une pluralité d'ouvertures à utiliser dans un système de lithographie par petits faisceaux multiples à particules chargées, les ouvertures étant disposées en groupes pour former une pluralité de zones de faisceau (91) sur la surface de la plaque, le procédé comprenant de :
- fournir un corps en forme de plaque, une face de surface (37) du corps étant pourvue d'un volume évidé conformément à une topologie ;
- fournir une pluralité de fentes (34) dans le corps en forme de plaque, dans lequel les fentes sont agencées afin d'être alignées avec les zones de faisceau sur la surface de plaque à ouverture ;
- couvrir le volume évidé de manière à former une pluralité de canaux de refroidissement (94) à l'intérieur du corps, dans lequel les fentes (34) sont disposés entre les canaux de refroidissement (94), la pluralité de canaux de refroidissement raccordant une entrée au niveau d'un côté du corps avec une sortie au niveau d'un autre côté du corps.

12. Procédé selon la revendication 11, dans lequel couvrir inclut de raccorder une ou plusieurs plaques de couvercle sur le corps par soudure laser.

13. Procédé selon la revendication 11 ou 12, dans lequel le corps est fabriqué en titane.

14. Procédé selon la revendication 11, dans lequel couvrir inclut de coller la plaque à ouverture à refroidir sur le corps.

15. Procédé de fabrication d'un corps de refroidissement à utiliser au sommet d'une surface d'une plaque pourvue d'une pluralité d'ouvertures à utiliser dans un système de lithographie par petits faisceaux multiples à particules chargées, les ouvertures étant disposées en groupes pour former une pluralité de zones de faisceau (91) sur la surface de la plaque, le procédé comprenant de:
- fournir un premier corps en forme de plaque, une face de surface du premier corps étant pourvue d'un premier volume évidé conformément à une première topologie;
- fournir un second corps en forme de plaque, une surface latérale du second corps étant pourvue d'un second volume évidé conformément à une seconde topologie;
- fournir une pluralité de fentes (34) dans le premier et le second corps en forme de plaque, dans lequel les fentes sont agencées afin d'être alignées avec les zones de faisceau sur la surface de plaque à ouverture et
- raccorder les surfaces du premier corps et du second corps l'une sur l'autre de sorte que le premier volume évidé et le second volume évidé forment une pluralité de canaux de refroidissement à l'intérieur d'un corps assemblé, dans lequel les fentes (34) sont disposés entre les canaux de refroidissement (94), la pluralité de canaux de refroidissement raccordant une entrée au niveau d'un côté du corps assemblé avec une sortie d'un autre côté du corps assemblé, de préférence dans lequel le raccordement est effectué en fournissant une couche adhésive entre les surfaces du premier corps et du second corps.
